# EUROPÄISCHE PATENTSCHRIFT

(11) **EP 0 989 594 B1**
(45) Veröffentlichungstag und Bekanntmachung des Hinweises auf die Patenterteilung: **19.06.2019**
(21) Anmeldenummer: 99810788.2
(22) Anmeldetag: 02.09.1999
(51) Int. Cl.: H01L 21/67, H01L 21/687

(54) **Prozesskammer**
Process chamber
Chambre de traitement

(30) Priorität: 15.09.1998 EP 98810916
(43) Veröffentlichungstag der Anmeldung: 29.03.2000
(73) Patentinhaber: Levitronix Technologies, LLC, Waltham MA 02451 (US)
(72) Erfinder: Schöb, Reto, Dr., 8604 Volketswil (CH)
(74) Vertreter: Intellectual Property Services GmbH

(56) Entgegenhaltungen:
- EP-A- 0 825 279
- WO-A-97/03225
- WO-A-97/15978
- WO-A-98/52214
- US-A- 5 439 519

## Beschreibung

Die Erfindung betrifft eine Prozesskammer, in welcher verschiedene Bearbeitungsschritte bei der Halbleiterfertigung ausgeführt werden können, gemäss dem Oberbegriff des unabhängigen Patentanspruchs.

Etliche Bearbeitungsschritte bei der Halbleiterfertigung, insbesondere bei der Herstellung von intergrierten Halbleiterschaltungen, erfolgen derart, dass der Wafer (eine Scheibe, auf welcher eine grosse Zahl solcher integrierter Halbleiterschaltungen angeordnet sind) in einer Prozesskammer rotiert wird. Dabei kommt oft noch hinzu, dass die einzelnen Schritte unter Reinraumbedingungen ausgeführt werden müssen. In den einzelnen Bearbeitungsschritten werden insbesondere Medien wie Flüssigkeiten (z.B. Ätzflüssigkeiten, Reinigungsflüssigkeiten, Fotolacke, Entwickler, etc.), Dämpfe (z.B. Metalldämpfe oder Flüssigkeitsdämpfe, etc.), Gase (Ätzgase, Sauerstoff zur Oxidation, Spülgase, Schutzgase, etc.), Suspensionen (z.B. zur Herstellung von Passivierungsschichten und anderen Dickfilmschichten), geschmolzenes Polysilizium, elektromagnetische Wellen, lonenstrahlen und andere mehr auf den Wafer appliziert bzw. wirken auf den Wafer ein. Beispielhaft sollen nachfolgend einige ausgewählte Bearbeitungsschritte kurz genannt werden, welche in einer Prozesskammer erfolgen, in welcher der Wafer rotiert wird.

Beispielsweise kann Fotolack aus einer Flüssigkeitsdüse (oder auch einer Spray-Düse) auf den rotierenden Wafer appliziert werden, wie es beispielsweise in der US-A-5,395,803 beschrieben ist. Alternativ ist es auch möglich, den Fotolack auf den ruhenden Wafer aufzutragen und diesen anschliessend zu rotieren, wie dies beispielsweise in der US-A-4,822,639 beschrieben ist.

Aufgrund der erhöhten Obeflächenspannung am Rand des Wafers kommt es hier oft zu leichten Überhöhungen, die unerwünscht sind und entfernt werden müssen. Dies erfolgt, indem auf den rotierenden Wafer im peripheren Bereich ein Lösungsmittel appliziert wird, wie es z.B. in der US-A-4,510,176 beschrieben ist. Dieser Bearbeitungsschritt kann beispielsweise auch zusammen mit dem Auftragen des Fotolacks kombiniert werden, was beispielsweise in der US-A-5,773,083 beschrieben ist.

Bei einem anderen Bearbeitungsschritt werden beispielsweise Suspensionen appliziert und dadurch Passivierungsschichten auf dem Wafer erzeugt. Dabei werden ähnlich wie bei der Fotolackbeschichtung beispielsweise Flüssigkeiten mit kleinsten Glas- oder Siliziumdioxidteilchen aufgetragen, die dann die Passivierungsschicht erzeugen. Derartige Bearbeitungsschritte sind beispielsweise in der US-A-5,376,176 oder in der US-A-5,328,871 beschrieben. Bei auf diese Weise hergestellten Schichten ist ebenfalls ein Bearbeitungsschritt erforderlich, in welchem Kantenüberhöhungen entfernt werden (wie z.B. in der US-A-4,732,785 beschrieben).

Ferner ist es auch möglich, auf rotierenden Wafern Dünnfilmschichten zu erzeugen, z.B. aus Siliziumdioxid, aus Metallen, oder aus Kohlenstoff (DLC = Diamond Like Carbon). Zu diesem Zweck werden die Wafer mittels bekannter Verfahren wie beispielsweise CVD-Verfahren (Chemical Vapour Deposition) oder PVD-Verfahren (Physical Vapour Deposition) beschichtet. Bei diesen Verfahren kann durch die Rotation des Wafers die Homogenität der Beschichtung des Wafers vorteilhaft beeinflusst werden, insbesondere dann, wenn der Wafer sehr schnell rotiert, z.B. mit Drehzahlen bis zu 16.000 rpm. Derartige Verfahren sind beispielsweise in der US-A-5,630,881 beschrieben.

Ferner sind derartige Verfahren auch dazu geeignet, beispielsweise durch Auftragen von geschmolzenem flüssigem Silizium auf einen rotierenden Teller polykristalline Silizium-Wafer zu herzustellen, ähnlich wie dies bei der Erzeugung der "dicken" Schichten bereits beschrieben worden ist. Dies ist beispielsweise in der US-A-4,561,486 beschrieben.

Weiterhin ist es auch möglich, auf einen rotierenden Wafer flüssige oder gasförmige Lösungsmittel zum Entfernen von Beschichtungen zu applizieren, z.B. zum Entfernen von Fotolacken. Dies ist z.B. in der US-A-4,749,440 oder in der US-A-4,510,176 beschrieben.

Darüberhinaus ist es auch möglich, den rotierenden Wafer für verschiedene Ätzprozesse auszunutzen. Dies ist insofern von Vorteil, als dabei eine homogene Ätzgeschwindigkeit üder den ganzen Wafer erreicht wird, was insbesondere von Wichtigkeit sein kann um ein Unterätzen zu vermeiden. Wird beispielsweise aus einer Düse Ätzflüssigkeit auf den rotierenden Wafer appliziert, so bildet sich ein homogener Ätzfilm aus, welcher gesteuert durch die Flüssigkeitszufuhr gleichmässig erneuert wird. Dies ist beispielsweise in der US-A-4,903,717 oder der US-A- 4,350,562 beschrieben. Alternativ ist es auch möglich, den Wafer auf einem Flüssigkeitsfilm rotieren zu lassen, wie dies in der US-A-4,350,562 beschrieben ist.

Bei anderen Ätzprozessen werden ätzende Dämpfe oder ätzende Gase zum Ätzen der Wafer eingesetzt, wie dies beispielsweise in der US-A-5,370,741, der US-A-5,174,853 oder der US-A-5,248,380 beschrieben ist. Der Wafer, welcher diesen Dämpfen oder Gasen ausgesetzt ist, wird während des Ätzprozesses ebenfalls rotiert. Bei diesem Ätzprozess ist es auch möglich, gleichzeitig beide Seiten eines Wafers zu ätzen (US-A-4,857,142). Beim sogenannten "Plasma-Ätzen" wird ein mit Hilfe eines elektrischen Felds ionisiertes Gas ("Plasma") zum Ätzen eingesetzt. Dies ist beispielsweise in der US-A-4,230,515 beschrieben. Bei all den beschriebenen Ätzprozessen ist es von Vorteil, wenn der Wafer rotiert wird.

Ferner ist es auch möglich, Ionenimplantationen auf rotierenden Wafern durchzuführen. Hierbei wird der Wafer, der z.B. mit einer Drehzahl von etwa 500-1500 rpm rotiert, mit lonenstrahlen beschossen. Hierzu sind normalerweise mehrere Wafer aus einem Drehteller angeordnet, wie dies z.B. in der US-A-4,745,287 beschrieben ist.

Weitere Bearbeitungsschritte mit rotierenden Wafern betreffen das Waschen der Wafer ("spin-rinsing") ähnlich wie beim "spin-etching", wobei der Wafer mit Reinigungsflüssigkeit beaufschlagt wird, z.B. mit Reinstwasser. Auch das Trocknen der Wafer ist so möglich: Flüssigkeitsreste werden durch Zentrifugalkräfte ("centrifugal wafer dryer") nach aussen geschleudert, siehe z.B. US-A-4,300,581.

Obgleich vorstehend nur eine ausgewälte Anzahl von Prozessen bzw. Prozessschritten beschrieben sind, gibt es noch zahlreiche weitere solcher Prozessschritte oder Bearbeitungsschritte, die in einer Prozesskammer mit rotierendem Wafer durchgeführt werden. Dabei werden in der Regel mit Hilfe von Applikatoren wie Düsen und Düsensysteme (Köpfe mit einer Vielzahl von Düsen), Rohrsystemen, Strahlenquellen, Elektroden, Heizelementen und Heizstrahlern, verschiedene Medien - darunter soll auch Strahlung verstanden werden - wie Flüssigkeiten, Suspensionen mit Feststoffen, Gase und Dämpfe, elektrogmagnetische Felder, lonenstrahlen etc. auf den Wafer appliziert.

Der Wafer wird dabei zumeist einzeln rotiert, oder aber es werden mehrere Wafer gemeinsam mit Hilfe einer enstprechenden rotierbaren Haltevorrichtung rotiert. Diese Haltevorrichtung wird im folgenden der Einfachheit halber als Drehkopf bezeichnet. Der Drehkopf, der den Wafer hält und rotiert, wird oft über eine rotierende Welle zumeist von unten her, manchmal auch von oben her, angetrieben. Dabei wird die rotierende Welle über eine Dichtung von unten her oder von oben her in den Innenraum der Prozesskammer eingeführt. Der Antriebsmotor befindet sich in der Regel ausserhalb des Innenraums der Prozesskammer, um den Innenraum der Prozesskammer von Verunreinigungen freizuhalten (Reinraumbedingungen) und um den Motor vor Korrosion zu schützen.

Die Applikatoren (Düsen, Düsensysteme, Rohrleitungen, Elektroden, Strahlungsquellen, etc.) befinden sich zwangsweise oberhalb oder unterhalb des Drehkopfs. Nur in Ausnahmefällen (Applikation von Gasen) ist es möglich, den Wafer von beiden Seiten her zu behandeln. In jedem Fall stellt aber der Antrieb des Drehkopfs von unten her oder von oben her eine Einschränkung im Hinblick auf die Anordnung der Applikatoren dar.

Diese Art, den Drehkopf anzutreiben und zu lagern stellt zusätzlich auch eine Einschränkung für die Zuführung des Wafers bzw. der Wafer dar. Der Wafer (die Wafer) kann (können) - bei einem Antrieb des Drehkopfs von unten - nicht von unten her zugeführt werden. Meistens ist auch eine Zufuhr von oben her nicht möglich wegen der Anordnung der Applikatoren, sodass in solchen Fällen der Wafer praktisch nur von der Seite her - genauer gesagt von seitlich oberhalb des Drehkopfs zugeführt werden kann. Dies erschwert erheblich die Zentrierung des Wafers und limitiert ausserdem die Freiheit der Anordnung der Applikatoren, weil ja der freie Zugang von der Seite her bis zur Mitte des Drehkopfs gewährleistet sein muss.

Aus der WO 97/15978 ist eine Vorrichtung für Bearbeitungsschritte bei der Halbleiterfertigung bekannt, welche die Merkmale des Oberbegriffs des Anspruchs 1 aufweist.

Es ist daher eine Aufgabe der Erfindung, eine Prozesskammer vorzuschlagen, in welcher verschiedene Bearbeitungsschritte bei der Halbleiterfertigung ausgeführt werden können, bei welcher Prozesskammer die genannten räumlichen Beschränkungen hinsichtlich der Anordnung von Applikatoren nicht vorliegen. Auch die Zuführbarkeit des Wafers soll einfacher möglich sein als bei bekannten Prozesskammern.

Diese Aufgabe wird durch eine Prozesskammer gelöst, wie sie durch die Merkmale des unabhängigen Patentanspruchs charakterisiert ist. Insbesondere ist in der Prozesskammer ein rotatorisch antreibbarer Drehkopf angeordnet, welcher als Halter für ein im wesentlichen scheibenförmiges zu bearbeitendes Objekt dient, z.B. für einen Wafer. Ferner ist in der Prozesskammer mindestens ein Applikator vorgesehen zum Bereitstellen eines Mediums, welches auf das zu bearbeitende Objekt einwirkt. Radial um den Drehkopf herum angeordnet sind Mittel zur Lagerung und zum Antrieb des Drehkopfs vorgesehen. Die Mittel zur Lagerung und zum Antrieb umfassen einen ausserhalb des Gehäuses der Prozesskammer angeordneten Stator, welcher in einer Einbuchtung des Gehäuse angeordnet ist. Diese radiale Anordnung ermöglicht es, je nach Anordnung der Applikatoren, den Wafer zentral von unten her oder von oben her zuzuführen und erleichtert somit eine Zentrierung des Wafers. Ferner ist es durch die Anordnung der Mittel zur Lagerung und zum Antrieb radial um den Drehkopf herum möglich, den eingebrachten Wafer sowohl von oben her als auch von unten her zu bearbeiten, ohne dass dies durch eine Antriebswelle oder dergleichen ausgeschlossen ist.

Vorzugsweise sind die Mittel zur Lagerung und zum Antrieb des Drehkopfs so ausgebildet, dass sie den Drehkopf berührungsfrei lagern und antreiben, insbesondere umfassen diese Mittel eine magnetische Lagerungs-/ Antriebseinheit, die oft auch als "lagerloser Motor" bezeichnet wird.

Dabei kann die magnetische Lagerungs-/Antriebseinheit einen ausserhalb des Gehäuses der Prozesskammer angeordneten Stator umfassen und der Drehkopf innerhalb des Gehäuses angeordnet sein, wobei die (unmagnetische) Gehäusewand ein Spaltrohr bildet, welches den Innenraum des Gehäuses gegen aussen hin abdichtet. Dadurch kann einerseits der Spalt zwischen dem Drehkopf und dem Stator klein gehalten werden (was bei gleicher Durchflutung eine grössere Steifigkeit des Lagers zur Folge hat), andererseits bleibt ein möglicherweise korrosives Medium stets im Innenraum des Gehäuses und kann nicht nach aussen dringen.

Bei einem Ausführungsbeispiel der erfindungsgemässen Prozesskammer können sämtliche sechs Freiheitsgrade des Drehkopfs, nämlich die zwei Freiheitsgrade der Verschiebung in der Lagerebene, die axiale Verschiebung, die zwei Freiheitsgrade der Verkippung und die Rotation, aktiv ansteuerbar sein. Dies ermöglicht eine sehr genaue Positionierung des Drehkopfs im Hinblick auf jeden der Freiheitgrade, ist aber natürlich auch von der Elektronik her aufwendiger als die beiden nachfolgenden Ausführungsvarianten.

Bei einer dieser Varianten können zwei Freiheitsgrade des Drehkopfs aktiv ansteuerbar sein, nämlich die zwei Freiheitsgrade der Verschiebung in der Lagerebene, während die anderen vier Freiheitsgrade passiv stabilisiert sind. Dies verringert den Aufwand bei der Elektronik, dafür sind aber die axiale Verschiebung, die Rotation, sowie die zwei Freiheitsgrade der Verkippung lediglich passiv stabilisiert. Was die axiale Verschiebung und die Verkippung des Drehkopfs betrifft, heisst dies , dass ein aus seiner passiv stabilisierten Lage bezüglich einer dieser drei Freiheitsgrade ausgelenkter Drehkopf durch Reluktanzkräfte wieder in seine stabile Lage zurückgeführt wird, solange die Auslenkung nicht grösser als ein Schwellenwert ist. Beim Überschreiten dieses Schwellenwertes allerdings ist eine stabile Lagerung des Drehkopfs nicht mehr gegeben. Was die Rotation betrifft, heisst dies, dass der Drehkopf mit z.B. mit dem Lagerstator magnetisch gekoppelt sein kann und dieser Lagerstator selbst drehbar ausgebildet ist. Aufgrund der magnetischen Kopplung wird dann beim Drehen des Lagerstators der Drehkopf mitgedreht.

Bei einer anderen, besonders bevorzugten Variante, sind drei Freiheitsgrade des Drehkopfs aktiv ansteuerbar, nämlich die zwei Freiheitsgrade der Verschiebung in der Lagerebene und die Rotation, während die anderen drei Freiheitsgrade, nämlich die axiale Verschiebung und die beiden Freiheitsgrade der Verkippung, passiv stabilisiert sind. Dadurch ist einerseits der Aufwand in der Elektronik noch vergleichsweise gering, andererseits braucht aber der Stator nicht drehbar ausgebildet sein, sondern der Drehkopf kann mittels eines Drehfelds rotatorisch angetrieben werden.

Bei einer vorteilhaften Ausgestaltung der erfindungsgemässen Prozesskammer ist der Drehkopf so ausgebildet, dass das zu bearbeitende Objekt ausserhalb des Innenraums der Prozesskammer so mit dem Drehkopf verbunden werden kann, dass es von ihm gehalten wird. Das zu bearbeitende Objekt kann dann zusammen mit dem Drehkopf in den Innenraum der Prozesskammer gebracht werden. Dies hat den Vorteil, dass eine genaue Positionierung des Objekts, z.B. des Wafers, relativ zu dem Drehkopf ausserhalb des Innenraums der Prozesskammer erfolgen kann, wo der Drehkopf besser zugänglich ist. Ausserdem ist es auf diese Weise auch möglich, den Wafer nur ein einziges Mal sehr genau mit dem Drehkopf zu verbinden, und dann die aus dem Drehkopf und dem Wafer gebildete Einheit von einer Bearbeitungsstation zu einer anderen Bearbeitungsstation weiterzureichen, ohne dass der Wafer auf einem anderen Drehkopf erneut positioniert werden muss. Dies kann innerhalb eines Systems von mit Schleusen verbundenen Prozesskammern erfolgen, damit die Reinraumbedingungen nicht zwischenzeitlich verletzt werden, wobei der Reinheitsgrad bei aufeinanderfolgenden Prozesskammern stets zunimmt.

Der Drehkopf kann so ausgebildet sein, dass das von dem Drehkopf gehaltene Objekt - z.B. der Wafer - von beiden Seiten her von einem vom Applikator bereitgestellten Medium beaufschlagt werden kann. Dies ist insofern vorteilhaft, als beispielsweise beide Seiten des Wafers gleichzeitig bearbeitet werden können. Die Bearbeitung der beiden Seiten kann aber auch sequentiell erfolgen. Jedenfalls ist es möglich, beide Seiten des Wafers zu bearbeiten, ohne dass dazu der Wafer gedreht werden muss, wie dies der Fall ist, wenn er - wie bei einer Vielzahl der einleitend diskutierten Vorrichtungen aus dem Stand der Technik - auf einem Drehteller mit einer Antriebswelle aufliegt.

Der Drehkopf kann hierzu im wesentlichen ringförmig ausgebildet sein. Im Innern des Drehkopfs kann aber auch eine Scheibe mit Durchlasskanälen eingepasst sein, wobei das zu bearbeitende Objekt, z.B. der Wafer, vom Drehkopf in einem Abstand zu dieser Scheibe gehalten wird. Diese Scheibe kann ein Düsensystem bilden, durch welches hindurch der Wafer z.B. mit Dämpfen oder Gasen beaufschlagt werden kann.

Bei einer anderen Ausgestaltung der Prozesskammer kann der Drehkopf im wesentlichen scheibenförmig ausgebildet sein und das zu haltende Objekt kann in einem zentralen Bereich des Drehkopfs gehalten werden. Im peripheren Bereich um diesen zentralen Bereich herum ist der Drehkopf abfallend ausgebildet, damit eine auf das zu bearbeitende Objekt aufgebrachte Flüssigkeit, die beim rotatorischen Antrieb des Drehkopfs über das zu bearbeitende Objekt hinweg nach aussen strömt, über den peripheren Bereich des Drehkopfs ablaufen kann.

Bei einer Weiterbildung dieser Variante weist der Drehkopf um den peripheren, abfallend ausgebildeten Bereich herum eine Wanne auf, welche an ihrem Boden Durchtrittsöffnungen für die in der Wanne aufgefangene Flüssigkeit aufweist. Diese Variante ist insofern vorteilhaft, als dadurch der Luftspalt zwischen dem Drehkopf und dem Stator klein gehalten werden kann, andererseits die Flüssigkeit nicht noch durch diesen ohnehin schon kleinen Spalt ablaufen muss. Stattdessen kann die Flüssigkeit in der Wanne aufgefangen werden und durch die Durchtrittsöffnungen im Boden der Wanne ablaufen.

Bei einem weiteren Ausführungsbeispiel der Prozesskammer weist der als Halter für das zu bearbeitende Objekt, z.B. für den Wafer, dienende Drehkopf Mittel auf, mit deren Hilfe ein Unterdruck zu dem zu bearbeitenden Objekt geleitet wird, welcher das zu bearbeitende Objekt an dem Drehkopf festsaugt. Dies kann vorzugsweise sogar ausserhalb des Innenraums des Gehäuses der Prozesskammer erfolgen, sodass der Wafer an einem gut zugänglichen Ort auf den Drehkopf positioniert und dann angesaugt werden kann. Einmal angesaugt wird der Drehkopf mitsamt dem angesaugten Wafer dann in den Innenraum des Gehäuses der Prozesskammer transportiert. Zur Erzeugung des Unterdrucks an dem als Halter dienenden Drehkopf kann beispielsweise eine Vakuumpumpe vorgesehen sein, welche vorzugsweise induktiv gespeist wird.

Weitere vorteilhafte Varianten und Ausgestaltungen ergeben sich aus der nachfolgenden Beschreibung von Ausführungsbeispielen anhand der Zeichnung. Es zeigen, teilweise schematisch und/oder im Schnitt:
- Fig. 1: ein erstes Beispiel einer Prozesskammer,
- Fig. 2: ein zweites Beispiel einer Prozesskammer,
- Fig.3: einen Ausschnitt aus reiner erfindungsgemässen Prozesskammer, bei welchem der Stator in einer Einbuchtung in der Gehäusewand angeordnet ist,
- Fig. 4: eine Kennlinie, welchen den Zusammenhang zwischen der Rückstellkraft und der axialen Auslenkung des Drehkopfs zeigt bei passiver Stabilisierung des Drehkopfs in axialer Richtung,
- Fig. 5: ein Ausführungsbeispiel eines im wesentlichen ringförmigen Drehkopfs mit Mitteln zum Festsaugen des zu bearbeitenden Objekts, z.B. eines Wafers, am Drehkopf,
- Fig. 6: ein Ausführungsbeispiel eines im wesentlichen ringförmigen Drehkopfs, in dessen Inneren eine mit Durchlasskanälen versehene Scheibe angeordnet ist, welche ein Düsensystem bildet
und
- Fig. 7: ein Ausführungsbeispiel eines im wesentlichen scheibenförmigen Drehkopfs mit Mitteln zum Festsaugen des zu bearbeitenden Objekts, z.B. eines Wafers, in einem zentralen Bereich des Drehkopfs, und mit einer Wanne im peripheren Bereich des Drehkopfs, welche an ihrem Boden Durchtrittsöffnungen aufweist.

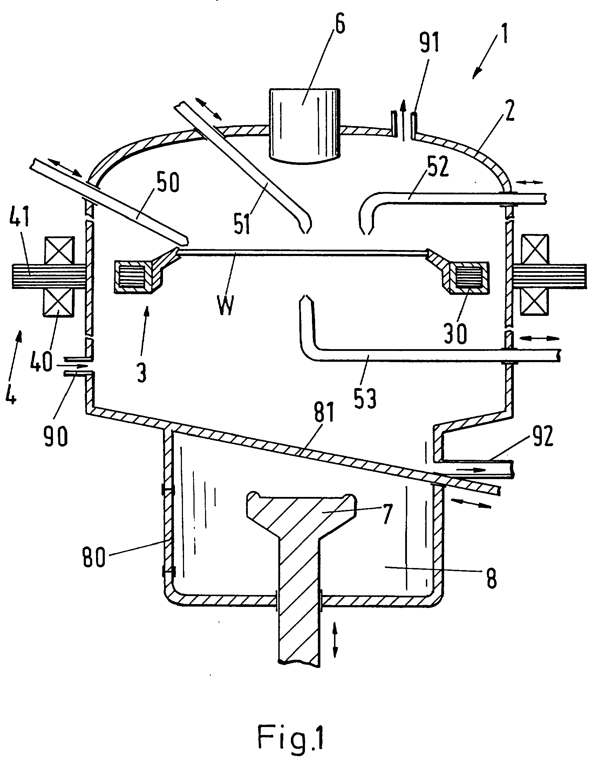

Das in Fig. 1 gezeigte Prozesskammer 1 umfasst ein Gehäuse 2, einen Drehkopf 3 mit magnetisch aktiven Elementen 30 (z.B. geblechtes Weicheisen), einen Lager-/ Antriebsstator 4 mit einer Statorwicklung 40 und mit magnetisch aktiven Elementen 41 wie geblechte Weicheisenteile und Permanentmagnete (nicht dargestellt). Der Lager-/Antriebsstator 4 ist radial um den Drehkopf 3 herum angeordnet, welcher einen Wafer W trägt. Die magnetisch aktiven Elemente sind ummantelt mit nichtmetallischen Stoffen (wie z.B. Teflon® = Polytetrafluorethylen, oder PVDF = Polyvinylidenfluorid oder einem keramischen Material), damit das Halbleitermaterial des Wafers W abgeschirmt ist. Ferner sind Applikatoren 50,51,52 für Flüssigkeiten und/oder Gase oberhalb des Wafers W angeordnet, sowie unterhalb des Wafers W ein Applikator 53, weil der Freiraum oberhalb und unterhalb des Drehkopfs 3 es gestattet, Applikatoren oberhalb und unterhalb des Drehkopfs 3 und damit des Wafers W anzuordnen. Die Applikatoren sind vorzugsweise verschiebbar und/oder verschwenkbar ausgebildet, was durch entsprechende Pfeile angedeutet ist. Ferner ist ein Belichtungskopf 6 für die Belichtung des Wafers W symbolisch dargestellt.

Zusammen mit dem Lager-/Antriebsrotor, der hier von dem Drehkopf 3 gebildet wird, bildet der Lager-/Antriebsstator 4 einen sogenannten "lagerlosen (Scheiben-)Motor", der Drehkopf 3 wird also berührungslos gelagert und angetrieben. Die im Stator 4 vorgesehenen Permanentmagnete (nicht dargestellt) definieren eine magnetische Vorspannung. Die Statorwicklung 40 umfasst einerseits eine Steuerwicklung zur Steuerung der Position des Drehkopfs 3 in der Lagerebene, also in der Ebene des Lager-/ Antriebsstators 4, andererseits umfasst sie eine Antriebswicklung zum Antreiben des Drehkopfs 3, wobei Steuerwicklung und Antriebswicklung eine gemeinsame Wicklung bilden können. Die Funktionsweise und verschiedenste Ausführungsformen eines solchen lagerlosen Motors sind an sich bekannt. Mit einem solchen lagerlosen Motor ist die Lagerung und der Antrieb eines Rotors, hier des Drehkopfs 3, gleichzeitig und am selben Ort möglich. An dieser Stelle soll noch erwähnt werden, dass bei dem in Fig. 1 gezeigten Beispiel drei Freiheitsgrade, nämlich die Verschiebung des Drehkopfs 3 in der Lagerebene und die Rotation, aktiv ansteuerbar sind, während die übrigen drei Freiheitsgrade, nämlich die axiale Verschiebung des Drehkopfs 3 (also die Verschiebung in Richtung der Längsachse) wie auch die zwei Freiheitsgrade der Verkippung, passiv stabilisiert sind.

Da der Stator 4 ausserhalb des Gehäuses 2 der Prozesskammer angeordnet ist, gibt es einen Bereich des Gehäuses 2, der im Luftspalt zwischen dem Drehkopf 3 und dem Stator 4 angeordnet ist. Um den Luftspalt möglichst klein zu halten und damit die Verluste zu reduzieren, kann das Gehäuse in diesem Bereich dünner ausgebildet sein oder auch aus einem Material gefertigt sein, welches magnetisch nicht leitend (beispielsweise PVDF = Polyvinylidenfluorid) oder der nur sehr schlecht leitend ist (beispielsweise Chrom-Nickel-Legierungen wie z.B. Hastelloy). Man spricht in einem solchen Fall von einem Spaltrohr, welches sich im Luftspalt des lagerlosen Motors befindet.

In Fig. 1 ist weiterhin ein Zuführmechanismus dargestellt, welcher einen Vakuumgreifer 7 umfasst. Dieser Vakuumgreifer 7 ist in Fig. 1 in einer Schleuse 8 angeordnet, welche zwei Schieber 80 und 81 umfasst. Der Schieber 80 ist in einer Ebene senkrecht zur Zeichenebene bewegbar, also quasi aus der Zeichenebene heraus und in die Zeichenebene hinein, und öffnet die Schleuse 8 nach aussen hin. Von aussen kann dann der Wafer W auf den Vakuumgreifer 7 aufgebracht werden. Dann wird der Schieber 80 geschlossen und der Schieber 81 geöffnet. Der Vakuumgreifer 7 kann dann den Wafer W zum Drehkopf 3 transportieren, wobei natürlich der Applikator 53 seitlich zurückgezogen werden muss, um das Zuführen des Wafers W nicht zu behindern. Alternativ kann es auch so sein, dass der Wafer W bereits ausserhalb der Schleuse 8 am Drehkopf 3 befestigt wird bzw. mit diesem verbunden wird, wie noch genauer erläutert werden wird. Der Drehkopf 3 wird dann zusammen mit dem Wafer W auf den Vakuumgreifer 7 aufgebracht und anschliessend in den Innenraum des Gehäuses 2 der Prozesskammer 1 transportiert. Dies hat den Vorteil, dass erstens das Befestigen bzw. Verbinden des Wafers W mit dem Drehkopf 3 an einem Ort erfolgen kann (nämlich ausserhalb der Schleuse), wo der Drehkopf 3 besonders gut zugänglich ist. Darüberhinaus wird beim axialen Transportieren des Drehkopfs 3 in Richtung seiner Sollposition der Drehkopf 3 schon vor dem Erreichen seiner Sollposition von dem Stator 4 praktisch in seine stabile Lage hineingezogen (passive axiale Stabilisierung). Schliesslich erkennt man in Fig. 1 noch einen Einlassstutzen 90 und einen Auslassstutzen 91 zum Zuführen und Abführen von Gasen und ein Auslassrohr 92 zum Abführen von Flüssigkeiten.

Mit Hilfe des Belichtungskopfs 6 ist es schliesslich möglich, den Wafer W auch zu belichten. Dies ist vor allen Dingen auch deshalb möglich, weil eine genaue Positionierung des Wafers W in der Lagerebene (natürlich innerhalb der Grenzen des Lufstpalts) möglich ist. Eine solche Prozesskammer 1 eignet sich daher insbesondere auch für die Herstellung von Halbleitern mit einfachen Strukturen wie beispielsweise Thyristoren (z.B. GTO's).

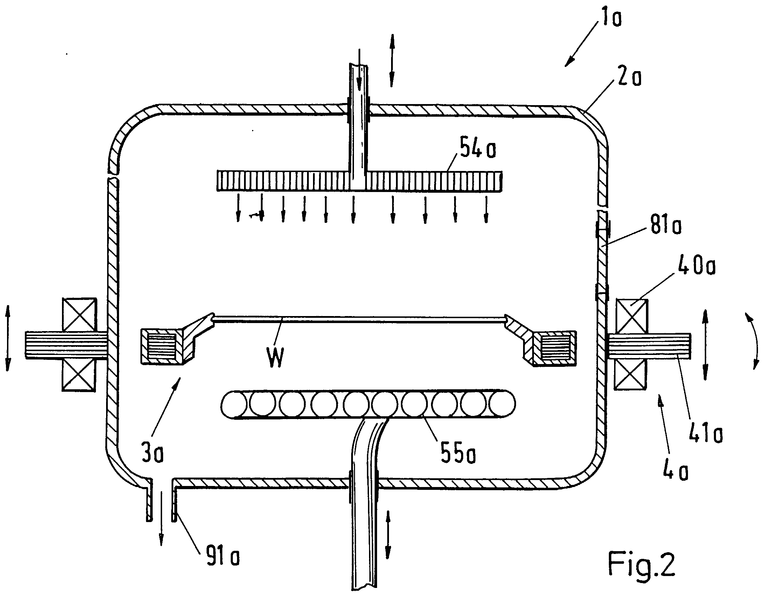

Fig. 2 zeigt ein weiteres Beispiel einer Prozesskammer. Im der folgenden Beschreibung der Fig. 2 sind gleiche Teile mit dem gleichen Bezugszeichen bezeichnet wie in Fig. 1, jedoch um den Buchstaben "a" ergänzt (mit Ausnahme des Wafers W). Infolgedessen umfasst die Prozesskammer 1a hier das Gehäuse 2a, in dessen Innenraum der Drehkopf 3a angeordnet ist, der den Wafer W trägt. der Drehkopf 3a wird von dem Stator 4a getragen und rotatorisch angetrieben. Der Stator 4a ist jedoch in axialer Richtung verschiebbar und in geringem Masse auch verkippbar, wie dies durch die entsprechenden Pfeile angedeutet ist. Dadurch lässt sich die axiale Position des Drehkopfes 3a im Innenraum des Gehäuses 2a justieren und die Verkippung des Drehkopfs 3a relativ zum (ortsfesten) Gehäuse 2a lässt sich ebenfalls innerhalb gewisser Grenzen justieren. Relativ zum Gehäuse 2a sind damit also alle sechs Freiheitsgrade des Drehkopfs 3a aktiv ansteuerbar. Betrachtet man den Drehkopf 3a relativ zum Stator 4a, so handelt es sich auch hier um eine Lagerung, bei welcher lediglich drei Freiheitsgrade des Drehkopfs 3a aktiv ansteuerbar sind, nämlich seine Position in der Lagerebene und die Rotation. Die axiale Verschiebung des Drehkopfs 3a wie auch die zwei Freiheitsgrade der Verkippung sind nämlich auch hier relativ zum Stator 4a passiv stabilisiert, auch wenn sie relativ zum Gehäuse 2a einstellbar sind.

Ferner ist in Fig. 2 noch ein Düsensystem 54a (Applikator) vorögesehen, welches beispielsweise ein Prozessgas in den Innenraum des Gehäuses 2a einleiten kann. Dieses Düsensystem 54a kann axial verschiebbar ausgebildet sein. Das Prozessgas wird über den Auslassstutzen 91a aus dem Innenraum der Prozesskammer 1a wieder abgeführt. Des weiteren erkennt man noch eine Heizspirale 55a (Applikator), welche unterhalb des Drehkopfs 3a angeordnet ist, und da der Wafer W von unten her frei zugänglich ist, kann eine homogene Erwärmung des Wafers W erreicht werden. Selbstverständlich können bei den Prozesskammern nach Fig. 1 und Fig. 2 noch weitere Applikatoren wie Elektroden oder Strahlenquellen oder sonstige Applikatoren im Innenraum des Gehäuses der Prozesskammer angeordnet sein. Die in Fig. 2 gezeigte Prozesskammer 1a ist besonders geeignet für CVD-Prozesse (Chemical Vapour Deposition).

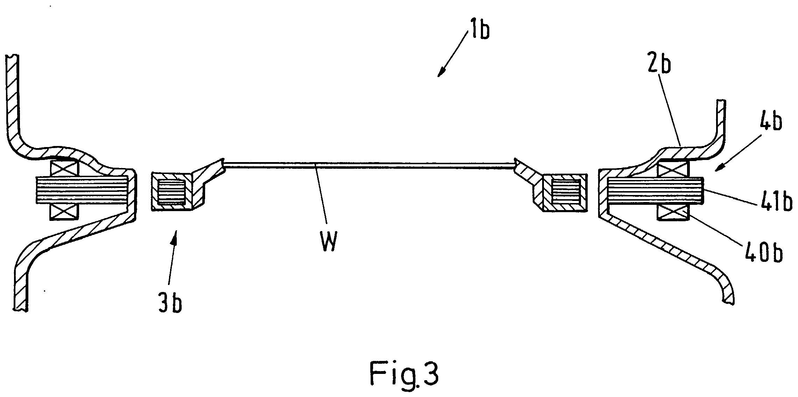

In Fig. 3 ist ein Ausschnitt aus einem Ausführungsbeispiel einer erfindungsgemässen Prozesskammer 1b gezeigt, bei welcher der Stator 4b in einer Einbuchtung des Gehäuses 2b angeordnet ist. Falls der Durchmesser des Drehkopfs 3b gegenüber dem Durchmesser des Innenraums des Gehäuses 2b klein gehalten werden soll, z.B. um den Wafer W mitsamt dem Drehkopf 3b leichter aus dem Innenraum des Gehäuses 2b entnehmen zu können, ist dieser Merkmal sehr vorteilhaft.

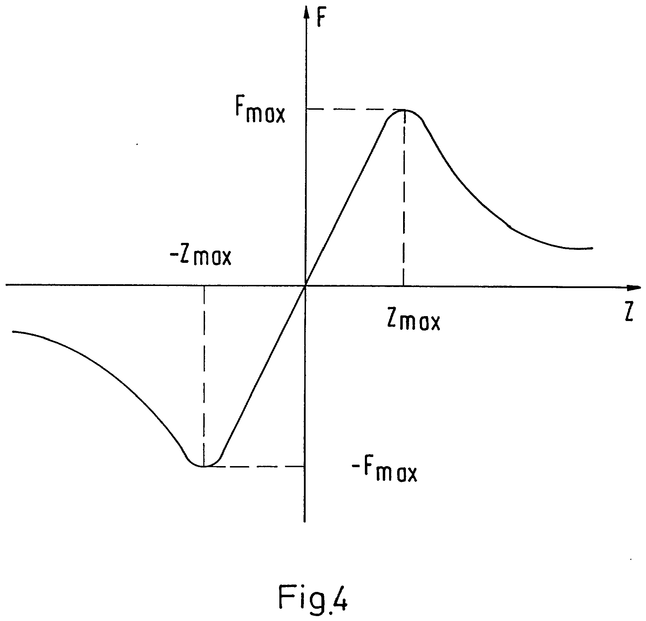

In Fig. 4 ist der Zusammenhang zwischen der Rückstellkraft F und der axialen Auslenkung z aus der Sollposition des Drehkopfs grafisch dargestellt. Man erkennt, dass in der jeweiligen positiven oder negativen axialen Richtung (z-Richtung) betrachtet die Rückstellkraft zunächst bis zu einer maximalen Auslenkung zₘₐₓ bzw. -zₘₐₓ die Rückstellkraft betragsmässig bis zu einem Wert Fₘₐₓ bzw. -Fₘₐₓ zunimmt, beim Überschreiten dieser Auslenkung jedoch wieder abnimmt. Das heisst, dass dann, wenn beim Überschreiten der Auslenkung zₘₐₓ bzw. -zₘₐₓ immer noch die gleiche Kraft in axialer Richtung auf den Drehkopf wirkt, die zu der entsprechenden Auslenkung geführt hat, entweicht der Drehkopf aus der Lagerung.

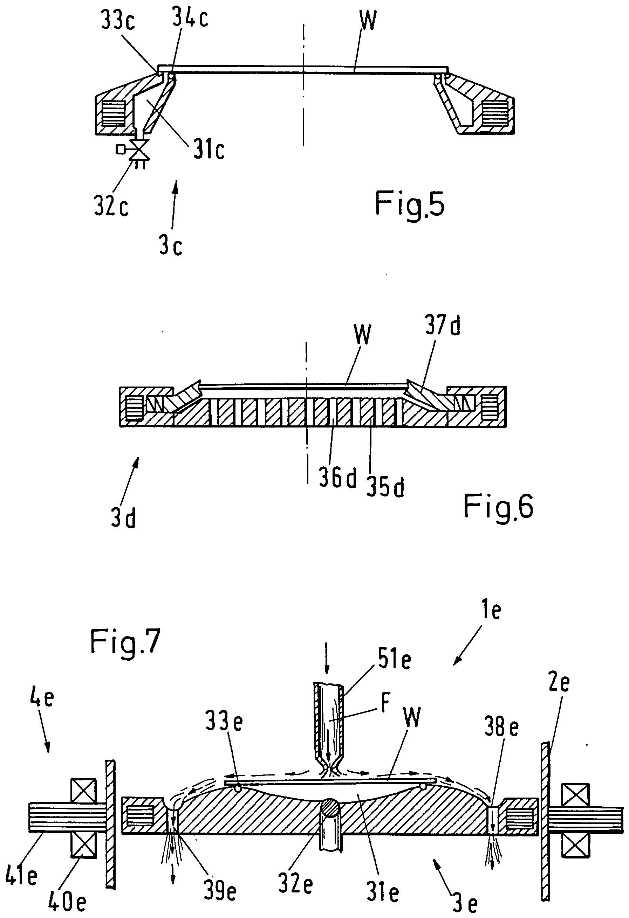

In Fig. 5 ist ein Ausführungsbeispiel eines Drehkopfs 3c gezeigt, der im wesentlichen ringförmig ausgebildet ist. Dies bedeutet, dass der Wafer W von beiden Seiten her bearbeitet werden kann. Der Drehkopf 3c weist Mittel zum Ansaugen des Wafers W auf in Form einer Unterdruckkammer 31c, in welcher über ein Ventil 32c ein Unterdruck erzeugt werden kann. Dadurch wird der Wafer gegen die O-Ringe 33c und 34c angesaugt. Dieser Vorgang kann ausserhalb des Innenraums des Gehäuses erfolgen. Anschliessend wird das Ventil 32c geschlossen, sodass der Unterdruck in der Unterdruckkammer 31c erhalten bleibt und der Wafer W an die O-Ringe 33c und 34c angesaugt bleibt. Der so mit dem Drehkopf 3c verbundene bzw. an dem Drehkopf 3c befestigte Wafer W kann dann zusammen mit dem Drehkopf 3c in den Innenraum der Prozesskammer (hier nicht dargestellt) eingebracht werden, wie dies bereits zuvor erläutert worden ist. Wenn die Unterseite des Wafers W beispielsweise noch so rauh ist, dass trotz Schliessen des Ventiels 32c der Wafer nicht fest an die O-Ringe 33c und 34c angesaugt bleibt, so kann auch anstelle des Ventils eine kleine Vakuumpumpe vorgesehen sein (nicht dargestellt), die induktiv gespeist wird, und zwar vorzugsweise von ausserhalb des Gehäuses. Zur Speisung kann beispielsweise ein Teil der Energie des Antriebsdrehfelds (jedoch nur während des Betriebs) genutzt werden.

Fig. 6 zeigt ein Ausführungsbeispiel eines Drehkopfes 3d, in dessen Inneren eine Scheibe 35d angeodnet ist, welche mit Durchlasskanälen 36d versehen ist. Diese Scheibe 35d wirkt als Düsensystem, durch welches hindurch der Wafer W (hier von unten) mit Gasen oder Dämpfen beaufschlagt werden kann. Der Wafer W wird mit Hilfe der gefederten Greifer 37d in einem Abstand von der Scheibe 35d (hier über der Scheibe 35d) gehalten. Der Wafer W ist also beidseitig zugänglich, wobei das Befestigen des Wafers W am Drehkopf 3d ebenfalls ausserhalb des Gehäuses des Prozesskammer erfolgen kann. Der so mit dem Wafer bestückte Drehkopf 3d kann dann in den Innenraum des Gehäuses des Prozesskammer eingebracht werden.

Fig. 7 zeigt ein Ausführungsbeispiel einer Prozesskammer 1e mit einem Gehäuse 2e, in dessen Innenraum ein im wesentlichen scheibenförmiger Drehkopf 3e angeordnet ist. Dieser Drehkopf 3e ist mit Mitteln zum Festsaugen des Wafers W versehen, und zwar in einem zentralen Bereich des Drehkopfs 3e. Diese Mittel umfassen ein Ventil 32e (z.B. ein Kugelventil). Wird nun durch das Kugelventil 32e hindurch Unterdruck erzeugt, so wird in der Unterdruckkammer 31e unter dem Wafer W ein Saugdruck erzeugt, welcher den Wafer W gegen den O-Ring 33e ansaugt. Schliesst man dann das Ventil 32e, so bleibt der Wafer W gegen den O-Ring 33e angesaugt. Dies kann, wie bereits früher erwähnt, ausserhalb des Innenraums des Gehäuses 2e der Prozesskammer 1e erfolgen. Alternativ kann auch anstelle des Ventils 32e eine Vakuumpumpe vorgesehen sein, welche induktiv gespeist wird, wie bereits anhand von Fig. 5 beschrieben, wobei Teile der Energie des Antriebsdrehfelds zur Speisung genutzt werden können. Um den zentralen Bereich herum fällt der Drehkopf nach aussen hin ab und mündet in eine Wanne 38e. Diese Wanne 38e ist an ihrem Boden mit Durchtrittsöffnungen 39e versehen. Wird nun aus einem Flüssigkeitsapplikator 51e eine Flüssigkeit F zentral auf den Wafer W appliziert, so strömt aufgrund der Rotation des Drehkopfs 3e die Flüssigkeit F über die Oberfläche des Wafers W hinweg nach aussen über den Waferrand hinweg, entlang der abfallenden Bereiche des Drehkopfs 3e in die Wanne 38e hinein und es wird ein Rückstau von nicht ablaufender Flüssigkeit F vermieden, sodass ein homogener Flüssigkeitsfilm auf dem Wafer W entstehen kann. Durch die Durchtrittsöffnungen 39e im Boden der Wanne kann die Flüssigkeit F nach unten gelangen, wo dann ein entsprechender Auslassstutzen (nicht dargestellt) im Gehäuse vorgesehen sein kann, durch welchen die Flüssigkeit F abgeführt werden kann. Wenn die Flüssigkeit F - wie hier gezeigt, nicht über den Rand des Drehkopfs 3e ablaufen muss, kann der Luftspalt sehr klein gewählt werden, was die Verluste reduziert. Selbstverständlich ist es aber auch möglich, den Drehkopf so auszubilden, dass die von dem Wafer W über den peripheren Bereich des Drehkopfs strömende Flüssigkeit durch den Luftspalt hindurch nach unten gelangt, wo sie dann abgeführt werden kann.

Wie bereits erwähnt sind die beschriebenen Ausführungsformen nur Beispiele, wie die erfindungsgemässe Prozesskammer ausgestaltet sein kann. Als Anwendungen kommen insbesondere die unzähligen Bearbeitungsschritte bei der Halbleiterfertigung in Betracht, speziell diejenigen, die bereits einleitend angesprochen worden sind.

## Patentansprüche

1. Prozesskammer (1), in welcher verschiedene Bearbeitungsschritte bei der Halbleiterfertigung ausgeführt werden können, wobei in der Prozesskammer ein rotatorisch antreibbarer Drehkopf (3) angeordnet ist, welcher als Halter für ein im wesentlichen scheibenförmiges zu bearbeitendes Objekt (W) dient, z.B. für einen Wafer, und wobei in der Prozesskammer mindestens ein Applikator (50,51,52,53) vorgesehen ist zum Bereitstellen eines Mediums, welches auf das zu bearbeitende Objekt (W) einwirkt, wobei radial um den Drehkopf (3) herum angeordnete Mittel (4) zur Lagerung und zum Antrieb des Drehkopfs (3) vorgesehen sind, **dadurch gekennzeichnet, dass** die Mittel (4) zur Lagerung und zum Antrieb einen ausserhalb des Gehäuses der Prozesskammer angeordneten Stator (4) umfassen, welcher in einer Einbuchtung des Gehäuses (2b) angeordnet ist.

2. Prozesskammer nach Anspruch 1, **dadurch gekennzeichnet, dass** die Mittel (4) zur Lagerung und zum Antrieb des Drehkopfs (3) so ausgebildet sind, dass sie den Drehkopf (3) berührungsfrei lagern bzw. antreiben, um die Bearbeitung des bearbeitenden Objekts (W) sowohl von oben her als auch von unten her zu ermöglichen.

3. Prozesskammer nach Anspruch 2, **dadurch gekennzeichnet, dass** die Mittel zum berührungsfreien Lagern und Antreiben des Drehkopfs eine magnetische Lagerungs-/Antriebseinheit umfassen.

4. Prozesskammer nach Anspruch 3, **dadurch gekennzeichnet, dass** die magnetische Lagerungs-/Antriebseinheit den ausserhalb des Gehäuses der Prozesskammer angeordneten Stator (4) umfasst und dass der Drehkopf (3) innerhalb des Gehäuses (2) angeordnet ist, wobei die Gehäusewand zwischen Stator und Drehkopf (3) als ein Spaltrohr ausgebildet ist, welches den Innenraum des Gehäuses (2) gegen aussen hin abdichtet.

5. Prozesskammer nach einem der Ansprüche 1 bis 4, **dadurch gekennzeichnet, dass** sämtliche sechs Freiheitsgrade des Drehkopfs (3), nämlich die zwei Freiheitsgrade der Verschiebung in der Lagerebene, die axiale Verschiebung, die zwei Freiheitsgrade der Verkippung und die Rotation, aktiv ansteuerbar sind.

6. Prozesskammer nach einem der Ansprüche 1 bis 4, **dadurch gekennzeichnet, dass** zwei Freiheitsgrade des Drehkopfs (3) aktiv ansteuerbar sind, nämlich die zwei Freiheitsgrade der Verschiebung in der Lagerebene, während die anderen vier Freiheitsgrade passiv stabilisiert sind.

7. Prozesskammer nach einem der Ansprüche 1 bis 4, **dadurch gekennzeichnet, dass** drei Freiheitsgrade des Drehkopfs (3) aktiv ansteuerbar sind, nämlich die zwei Freiheitsgrade der Verschiebung in der Lagerebene und die Rotation, während die anderen drei Freiheitsgrade passiv stabilisiert sind.

8. Prozesskammer nach einem der Ansprüche 1 bis 7, **dadurch gekennzeichnet, dass** der Drehkopf (3,3a,3b,3c,3d) so ausgebildet ist, dass das von dem Drehkopf gehaltene Objekt (W) von beiden Seiten her von einem vom Applikator (50,51,52,53;54a,55a) bereitgestellten Medium beaufschlagt werden kann.

9. Prozesskammer nach Anspruch 8, **dadurch gekennzeichnet, dass** der Drehkopf (3,3a,3b,3c,3d) im wesentlichen ringförmig ausgebildet ist.

10. Prozesskammer nach Anspruch 9, **dadurch gekennzeichnet, dass** im Innern des ringförmigen Drehkopfs (3d) eine Scheibe (35d) mit Durchlasskanälen (36d) eingepasst ist, wobei das zu bearbeitende Objekt (W) vom Drehkopf in einem Abstand von der Scheibe (35d) gehalten wird.

11. Prozesskammer nach einem der Ansprüche 1 bis 7, **dadurch gekennzeichnet, dass** der Drehkopf (3e) im wesentlichen scheibenförmig ausgebildet ist, um das zu haltende Objekt in einem zentralen Bereich des Drehkopfs (3e) zu halten, während der Drehkopf (3e) im peripheren Bereich um diesen zentralen Bereich herum abfallend ausgebildet ist, damit eine auf das zu bearbeitende Objekt aufgebrachte Flüssigkeit (F), die beim rotatorischen Antrieb des Drehkopfs (3e) über das zu bearbeitende Objekt (W) hinweg nach aussen strömt, über den peripheren Bereich des Drehkopfs (3e) ablaufen kann.

12. Prozesskammer nach Anspruch 11, **dadurch gekennzeichnet, dass** der Drehkopf (3e) um den peripheren, abfallend ausgebildeten Bereich herum eine Wanne (38e) aufweist, welche an ihrem Boden Durchtrittsöffnungen (39e) für die in der Wanne (38e) aufgefangene Flüssigkeit (F) aufweist.

13. Prozesskammer nach einem der vorangehenden Ansprüche, **dadurch gekennzeichnet, dass** der als Halter für das zu bearbeitende Objekt dienende Drehkopf (3c,3e) Mittel (32c,32e) aufweist, mit deren Hilfe ein Unterdruck zu dem zu bearbeitenden Objekt (W) geleitet wird, welcher das zu bearbeitende Objekt (W) an dem Drehkopf (3c,3e) festsaugt.

14. Prozesskammer nach Anspruch 13, **dadurch gekennzeichnet, dass** zur Erzeugung des Unterdrucks an dem als Halter dienenden Drehkopf (3c, 3e) eine Vakuumpumpe vorgesehen ist, welche vorzugsweise induktiv gespeist wird.

## Claims

1. Process chamber (1) in which various processing steps in the manufacture of semiconductors can be carried out, with a rotationally drivable rotary head (3) being arranged in the process chamber and serving as a holder for a substantially disc-shaped object to be processed (W), e.g. for a wafer, and with at least one applicator (50, 51, 52, 53) being provided in the process chamber for the provision of a medium which acts on the object to be processed (W), and means (4), which are arranged radially around the rotary head (3), being provided for the journalling and for the driving of the rotary head (3), **characterised in that** the means (4) for the journalling and for the driving comprise a stator (4) being arranged outside the housing of the process chamber and being arranged in an indentation of the housing (2b).

2. Process chamber in accordance with claim 1 **characterised in that** the means (4) for the journalling and for the driving of the rotary head (3) are designed in such a manner that they journal and/or drive the rotary head (3) respectively without contact in order to enable processing the object to be processed (W) both from above and from below.

3. Process chamber in accordance with claim 2 **characterised in that** the means for the journalling and for the driving of the rotary head without contact comprise a magnetic bearing / drive unit.

4. Process chamber in accordance with claim 3 **characterised in that** the magnetic bearing / drive unit comprises the stator (4) which is arranged outside the housing of the process chamber and that the rotary head (3) is arranged inside the housing (2), with the housing wall being formed as a tubular gap between the stator and the rotary head (3), which tubular gap seals off the inner space of the housing (2) against the outside.

5. Process chamber in accordance with one of the claims 1 to 4 **characterised in that** all six degrees of freedom of the rotary head (3), namely the two degrees of freedom of displacement in the bearing plane, the axial displacement, the two degrees of freedom of tilting and the rotation, can be actively controlled.

6. Process chamber in accordance with one of the claims 1 to 4 **characterised in that** two degrees of freedom of the rotary head (3) can be actively controlled, namely the two degrees of freedom of displacement in the bearing plane, whereas the other four degrees of freedom are passively stabilised.

7. Process chamber in accordance with one of the claims 1 to 4 **characterised in that** three degrees of freedom of the rotary head (3) can be actively controlled, namely the two degrees of freedom of displacement in the bearing plane and the rotation, whereas the other three degrees of freedom are passively stabilised.

8. Process chamber in accordance with one of the claims 1 to 7 **characterised in that** the rotary head (3, 3a, 3b, 3c, 3d) is designed in such a manner that the object (W) held by the rotary head can be charged from both sides with a medium which is provided by the applicator (50, 51, 52, 53; 54a, 55a).

9. Process chamber in accordance with claim 8 **characterised in that** the rotary head (3, 3a, 3b, 3c, 3d) is designed to be substantially in the shape of a ring.

10. Process chamber in accordance with claim 9 **characterised in that** in the interior of the ring-shaped rotary head (3d) a disc (35d) with passage channels (36d) is fitted in, with the object to be processed (W) being held at a distance from the disc (35d) by the rotary head.

11. Process chamber in accordance with one of the claims 1 to 7 **characterised in that** the rotary head (3e) is designed substantially in the shape of a disc in order to hold the object to be held in a central region of the rotary head (3e), whereas the rotary head (3e) is designed to have a declination in the peripheral region around this central region in order that a liquid (F) which is applied to the object to be processed and which flows outwardly over the object to be processed (W) when the rotary head (3e) is rotationally driven can run off over the peripheral region of the rotary head (3e).

12. Process chamber in accordance with claim 11 **characterised in that** the rotary head (3e) has a tub (38e) around the peripheral region with the declination, which tub (38e) has passage openings (39e) at its base for the liquid (F), which is caught in the tub (38e).

13. Process chamber in accordance with one of the preceding claims **characterised in that** the rotary head (3c, 3e) which serves as a holder for the object to be processed has means (32c, 32e) with the help of which a depression is conducted to the object to be processed (W) which sucks the object to be processed (W) fast at the rotary head (3c, 3e).

14. Process chamber in accordance with claim 13 **characterised in that** a vacuum pump, which is preferably inductively fed is provided for the production of the depression at the rotary head (3c, 3e), which serves as a holder.

## Revendications

1. Chambre de traitement (1) dans laquelle différentes étapes de traitement peuvent être réalisées dans la fabrication de semi-conducteurs, dans laquelle une tête rotative (3) qui peut être entraînée en rotation est disposée dans la chambre de traitement, qui sert de support pour un objet à traiter (W) étant sensiblement en forme de disque, par exemple pour un wafer, et dans laquelle au moins un applicateur (50, 51, 52, 53) est prévu dans la chambre de traitement pour fournir un médium, qui affecte l'objet à traiter (W), dans laquelle des moyens (4) disposés radialement autour de la tête rotative (3) sont prévus pour le support et l'entraînement de la tête rotative (3), **caractérisé en ce que** les moyens (4) pour le support et l'entraînement comprennent un stator (4) disposé à l'extérieur du boîtier de la chambre de traitement, ledit stator est disposé dans un renfoncement du boîtier (2b).

2. Chambre de traitement selon la revendication 1, **caractérisé en ce que** les moyens (4) de support et d'entraînement de la tête rotative (3) sont conçus de telle sorte qu'ils supportent ou entraînent la tête rotative (3) sans contact afin de permettre le traitement de l'objet à traiter (W) par le haut et par le bas.

3. Chambre de traitement selon la revendication 2, **caractérisé en ce que** les moyens de support et d'entraînement sans contact de la tête rotative comprennent une unité de support/d'entraînement magnétique.

4. Chambre de traitement selon la revendication 3, **caractérisé en ce que** l'unité de support/d'entraînement magnétique comprend le stator (4) disposé à l'extérieur du boîtier de la chambre de traitement et que la tête rotative (3) est disposée à l'intérieur du boîtier (2), dans laquelle la paroi du boîtier entre le stator et la tête rotative (3) est formée sous la forme d'une gaine à fente qui ferme l'intérieur du boîtier (2) de l'extérieur.

5. Chambre de traitement selon l'une des revendications 1 à 4, **caractérisé en ce que** les six degrés de liberté de la tête rotative (3) peuvent être commandés activement, à savoir les deux degrés de liberté de déplacement dans le plan du palier, le déplacement axial, les deux degrés de liberté d'inclinaison et la rotation.

6. Chambre de traitement selon l'une des revendications 1 à 4, **caractérisé en ce que** deux degrés de liberté de la tête rotative (3) peuvent être commandés activement, à savoir les deux degrés de liberté de déplacement dans le plan du palier, tandis que les quatre autres degrés de liberté sont stabilisés passivement.

7. Chambre de traitement selon l'une des revendications 1 à 4, **caractérisé en ce que** trois degrés de liberté de la tête rotative (3) peuvent être commandés activement, à savoir les deux degrés de liberté de déplacement dans le plan du palier et la rotation, tandis que les trois autres degrés de liberté sont stabilisés passivement.

8. Chambre de traitement selon l'une des revendications 1 à 7, **caractérisé en ce que** la tête rotative (3, 3a, 3b, 3c, 3d) est conçue de telle sorte que l'objet (W) tenu par la tête rotative peut être alimenté des deux côtés par un médium prévu par l'applicateur (50, 51, 52, 53 ; 54a, 55a).

9. Chambre de traitement selon la revendication 8, **caractérisé en ce que** la tête rotative (3, 3a, 3b, 3c, 3d) est sensiblement en forme d'anneau.

10. Chambre de traitement selon la revendication 9, **caractérisé en ce qu'**un disque (35d) avec des canaux de passage (36d) est monté à l'intérieur de la tête rotative annulaire (3d), dans laquelle l'objet à traiter (W) est tenu par la tête rotative à une distance du disque (35d).

11. Chambre de traitement selon l'une des revendications 1 à 7, **caractérisé en ce que** la tête rotative (3e) est sensiblement en forme de disque pour tenir l'objet à tenir dans une région centrale de la tête rotative (3e), tandis que la tête rotative (3e) est conçue de manière inclinée dans la région périphérique autour de cette région centrale, de sorte qu'un liquide (F) qui est appliqué sur l'objet à traiter et s'écoule vers l'extérieur sur l'objet à traiter (W) lorsque la tête rotative (3e) est entraînée en rotation, peut s'écouler sur la région périphérique de la tête rotative (3e).

12. Chambre de traitement selon la revendication 11, **caractérisé en ce que** la tête rotative (3e) a un carter (38e) autour de la région périphérique formée de manière inclinée, ledit carter (38e) ayant à son fond des ouvertures de passage (39e) pour le liquide (F) recueilli dans le carter (38e).

13. Chambre de traitement selon l'une des revendications précédentes, **caractérisé en ce que** la tête rotative (3c, 3e) servant de support pour l'objet à traiter comporte des moyens (32c, 32e) au moyen desquels une dépression est conduite vers l'objet à traiter (W), ladite dépression aspirant l'objet (W) à traiter sur la tête rotative (3c, 3e).

14. Chambre de traitement selon la revendication 13, **caractérisé en ce qu'**une pompe à vide, alimentée de préférence par induction, est prévue sur la tête rotative (3c, 3e) servant de support pour générer la dépression.
